Europäisches Patentamt

European Patent Office

Office européen des brevets

(11) Publication number: **0 197 679 B1**

# EUROPEAN PATENT SPECIFICATION

(45) Date of publication of patent specification: **12.06.91**     (51) Int. Cl.⁵: **H01L 31/18, H01L 31/06**

(21) Application number: **86301939.4**

(22) Date of filing: **17.03.86**

(54) Method of severing smaller area semiconductor devices from a large-area of coated semiconductor.

(30) Priority: **01.04.85 US 718770**

(43) Date of publication of application:
**15.10.86 Bulletin 86/42**

(45) Publication of the grant of the patent:
**12.06.91 Bulletin 91/24**

(84) Designated Contracting States:
**CH DE FR GB IT LI NL**

(56) References cited:
**EP-A- 0 111 394**
**US-A- 4 138 304**
**US-A- 4 445 043**
**US-A- 4 495 732**
**US-A- 4 567 642**

(73) Proprietor: **ENERGY CONVERSION DEVICES, INC.**
**1675 West Maple Road**
**Troy Michigan 48084(US)**

(72) Inventor: **Nath, Prem**
**245 Prospect**
**Rochester Michigan 48063(US)**
Inventor: **Singh, Avtar**
**13320 North Norfolk**
**Detroit Michigan 48235(US)**

(74) Representative: **Jackson, Peter Arthur et al**
**Gill Jennings & Every, 53-64 Chancery Lane**
**London WC2A 1HN(GB)**

## Description

It is now possible to prepare by glow discharge or vapor deposition thin film amorphous silicon or germanium alloys of electronic device quality in large areas. Unlike crystalline silicon, amorphous silicon alloys can be deposited in multiple layers over large area substrates to form solar cells in a high volume, continuous processing system. Such continuous processing systems are disclosed in US-A-4,400,409, US-A-4,410,588, US-A-4,485,125 and US-A-4,492,181. As disclosed in these patents, a web substrate is continuously advanced through a succession of deposition chambers, in each of which a specific semiconductor material is deposited. In making a solar cell of p-i-n type configuration, a p-type amorphous silicon alloy is deposited in one chamber, an intrinsic amorphous silicon alloy is deposited in a second and, an n-type amorphous silicon alloy is deposited in a third chamber.

In many cases it is necessary to sever large-area photovoltaic material into smaller photovoltaic cells. "Severing" includes cutting, shearing, punching, die cutting, and slitting. Production of photovoltaic devices on a continuous web requires severing to produce discrete photovoltaic cells.

A typical thin film photovoltaic cell includes a substrate that forms the base electrode or has a base electrode region cn it, a semiconductor body deposited on the base electrode and a relatively transparent electrically conductive top electrode member. Transparent electrode members are generally formed of a transparent oxide material such as indium tin oxide, tin oxide, indium oxide, cadmium stannate and zinc oxide. Severing a photovoltaic cell of this type tends to produce one or more short circuit current paths between the top electrode and the base electrode. The transparent conductive oxide material is relatively brittle and produces shards when subjected to a shearing force in the cutting process. These shards produce the short circuit current paths. Shards may be avoided by certain scribing techniques, such as chemical etching, plasma etching, laser scribing and water jet scribing. While all of these techniques are effective, they require extra processing steps and require expensive additional hardware.

EP-A-0111394 discloses the severing of a large area solar cell in a one-step blanking operation.

According to the invention, a method for severing a smaller area semiconductor device from a larger area semiconductor structure without creating short circuits; the larger area structure including amorphous semiconductor material disposed on an electrically conductive substrate and coated with a brittle electrically conductive coating on the side thereof opposite to said substrate, is characterized by placing a rigid support member close to the severing line of the smaller area semiconductor device, the conductive coating of said larger area semiconductor structure being proximate said rigid support member; and utilizing a cutting die to apply a shearing force to the substrate side of the larger area semiconductor structure towards the rigid support member to punch through and sever the smaller area device from the larger area structure.

The invention provides a novel severing technique that avoids short circuiting by shards, yet does not require additional process steps or expensive equipment.

In one embodiment of the invention a protective member, such as a sheet of cardboard, paper or synthetic polymer or combination thereof, is disposed between the brittle coating side of the semiconductor device and the support means so as to prevent damage to the transparent electrode during the cutting. The protective member may be removably affixed to the device by a contact adhesive. In other cases, the protective member may be formed of a transparent encapsulant material that remains in place after the severing process.

Figure 1 is a fragmentary, cross-sectional view of a tandem photovoltaic device of the type which may be employed in the practice of the invention.

Figure 2 is a schematic view of a multiple chamber deposition apparatus of the type which may be employed for the fabrication of the tandem photovoltaic cell of Figure 1.

Figure 3A is a cross-sectional view of photovoltaic material disposed for severing into a smaller area cell.

Figure 3B is a cross-sectional view of the photovoltaic material of Figure 3A after severing.

Figure 4 is a top view of a small-area photovoltaic cell, severed from a larger area photovoltaic material according to the invention and illustrating the formation of a transparent oxide free region along its periphery.

Figure 5 is a perspective view of a die-cutting station for severing large-area semiconductor material into a plurality of small-area devices according to the invention.

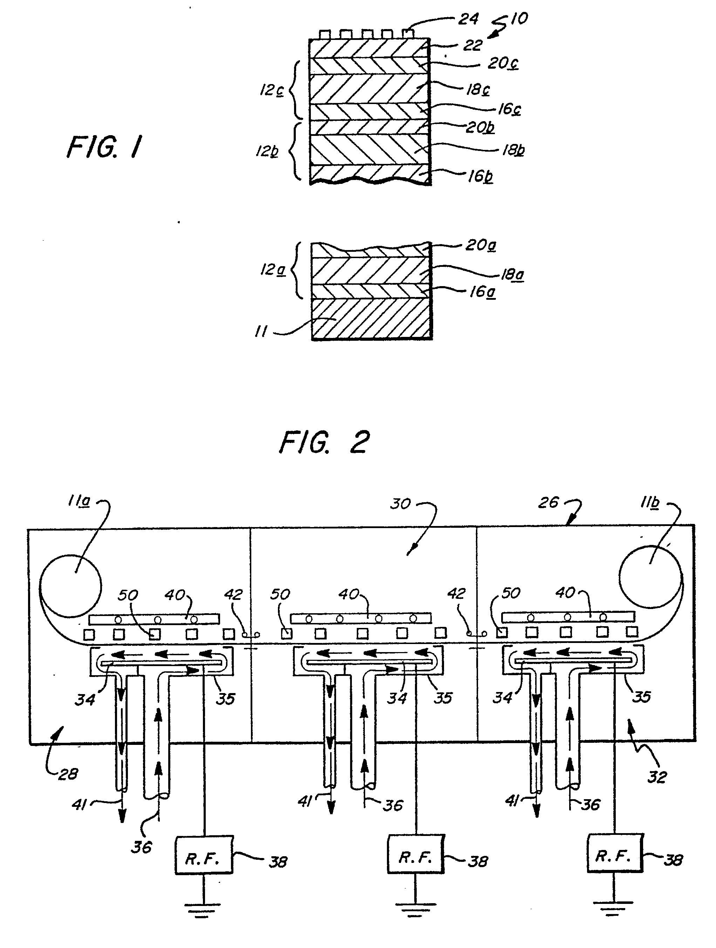

Figure 1 shows an n-i-p type photovoltaic device 10 such as a solar cell made up of individual n-i-p type cells 12a, 12b and 12c. Below the lowermost cell 12a is a substrate 11 which may be formed of a transparent glass or synthetic polymeric member, or from a metallic material such as stainless steel, aluminum, tantalum, molybdenum, chrome, or formed from metallic particles embedded within an insulator.

Each of the cells 12a, 12b and 12c is preferably fabricated with a thin film semiconductor body containing at least a silicon or silicon:germanium alloy. Each of the semiconductor bodies includes a p-type conductivity semiconductor layer 20a, 20b and 20c; a substantially intrinsic semiconductor layer 18a, 18b and 18c; and an n-type conductivity semiconductor layer 16a, 16b and 16c. Cell 12b is an intermediate cell and additional intermediate cells may be stacked on the illustrated cells or the tandem cell may include only two cells. Although n-i-p photovoltaic cells are illustrated, this invention may be advantageously practiced with differently configured photovoltaic cells including single or multiple p-i-n cells, Schottky barrier cells, p-n cells as well as with any other semiconductor device having an appropriate top electrode.

A TCO (transparent conductive oxide) layer 22, preferably formed of a material such as tin oxide, indium oxide, indium tin oxide, zinc oxide, cadmium stannate or combinations thereof is disposed on p-layer 20c of cell 12c as the top electrode of cell 10. An electrode grid 24 may be added to increase current collection efficiency.

Apparatus 26 of Figure 2 deposits amorphous semiconductor layers of n-i-p configuration onto the surface of a web of substrate material 11 which is continuously fed through the apparatus. In a first deposition chamber 28 an n-type conductivity semiconductor layer is deposited onto the deposition surface of the substrate 11; in a second deposition chamber 30 an intrinsic semiconductor layer is deposited on the p-type layer; and in a third deposition chamber 32, a p-type semiconductor layer is deposited on the intrinsic layer.

The deposition process employs a glow discharge. Each of deposition chambers 28, 30 and 32 includes a cathode 34; a shield 35 disposed about each cathode; a process gas supply conduit 36; a source of electromagnetic power 38; a process gas and plasma evacuation conduit 41; a plurality of transversely extending magnetic elements 50; a plurality of radiant heating elements 40 and a gas gate 42 operatively interconnecting the intrinsic deposition chamber to each adjacent dopant chamber.

The supply conduits 36 deliver process gas mixtures to the plasma regions in each deposition chamber between cathode 34 and substrate 11. Cathode shields 35 confine the process gases within the cathode region of each deposition chamber.

Power generator 38 operates in conjunction with cathodes 34, radiant heaters 40 and electrically grounded substrate 11 to form the plasma that disassociates the reaction gases entering the deposition chambers. The disassociation products deposit as semiconductor layers. Magnetic substrate 11 is maintained substantially flat by magnetic elements 50 which urge substrate 11 upwardly, out of its normal sagging path of travel.

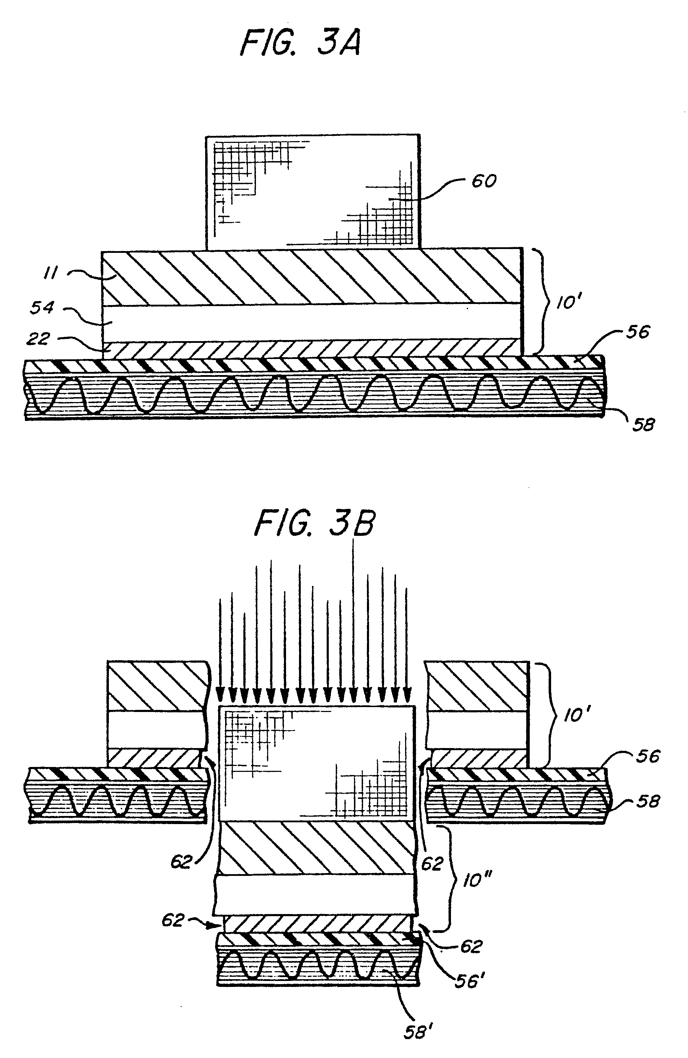

In Figure 3A, which is not drawn to scale, a relatively large piece of photovoltaic cell material 10' is disposed for cutting. Material 10' is generally similar to photovoltaic cell 10 of Figure 1 and includes a semiconductor body 54, comprising several semiconductor layers, a substrate 11 and a transparent electrode layer 22. A protective layer 56 is disposed in contact with electrode 22. Protective layer 56 prevents mechanical damage to electrode 22 during severing operations and subsequently. Protective layer 56 may be formed from a wide variety of materials, for example, a thin film of polyethylene, vinyl, a transparent encapsulant or other synthetic polymers, paper and cardboard. Protective layer 56 may be affixed to the electrode layer 22 with adhesive that can be peeled off, or may simply be disposed in contact with electrode 22. A support member 58 is disposed on protective layer 56 opposite electrode 22. Support member 58 is resilient, and may be corrugated cardboard, to cushion photovoltaic device 10' during severing. Other resilient support members could include rubber, plastics and paper. Support member 58 could also be rigid, for example, a cutting die, or the stationary block of a shear press. A rigid support member is disposed in relatively close proximity to the severing line of photovoltaic device 10'. A cutting die 60 is disposed proximately the substrate side of semiconductor device material 10'. Cutting die 60 severs photovoltaic device 10'.

In Figure 3B, the elements of Figure 3A are shown immediately following the severing step. A force has been applied to cutting die 60 causing it to "punch out" a portion 10" of photovoltaic material 10'. A portion 58' of resilient support member 58 and a portion of 56' of protective layer 56 have also been punched out with smaller cell 10". Photovoltaic material 10' is generally not more than about 0.2 mm thick whereas support member 58 is generally 4-5 mm thick. The severing step does not usually punch completely through cardboard support member 58, but only partially severs the cardboard and embeds cut portion 10" in cardboard support member 58 in it, from which it may be removed.

A particularly notable feature of the novel process, illustrated in Figure 3B is disappearance of portions of electrode layer 22 proximate the cut edges of photovoltaic cell material 10' and of cut portion 10". These regions 62 are devoid of the electrode material. When a semiconductor device having a transparent oxide electrode on one surface is severed from the opposite surface, portions of that electrode proximate the cut edge shatter and the resulting shards fall away from the cut regions. As a result, zones 62, free of the transparent oxide material, are created. These zones prevent the short circuiting. If the same device were cut from the transparent oxide surface, shards of TCO material penetrate the semiconductor body, establishing short circuit current paths between the substrate electrode and TCO layer.

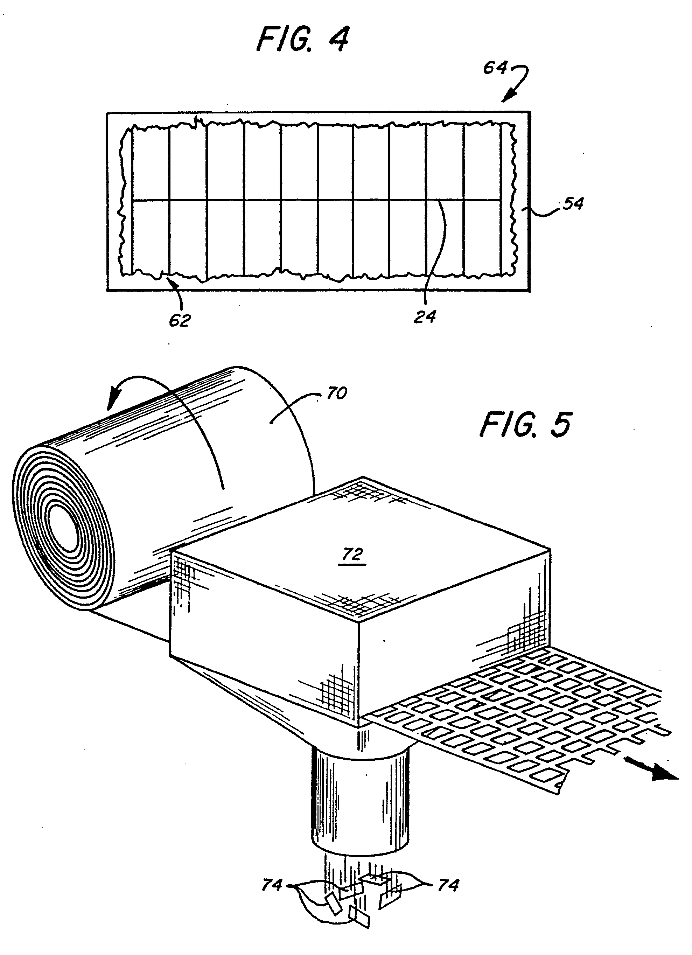

Figure 4 is a top view of a representative small-area photovoltaic cell 64 which has been severed in according to the invention. Cell 64 includes a grid pattern 24 disposed on the TCO layer. Zone 62, free of transparent oxide, is disposed along the periphery of cell 64 exposing the underlying semiconductor body 54.

A supply of large-area photovoltaic cell material may have a protective layer adhesively affixed to, extruded or screen printed onto its transparent oxide surface. This supply of material, in sheets or wound on a roll, may be severed into smaller-area photovoltaic cells, according to the invention, as needed, without the necessity for any scribing, etching, masking or other patterning before severing.

In Figure 5 a roll 70 of photovoltaic material covered by a protective layer is continuously fed to a die cutting station 72. At station 72, a conventional die cutting technique is employed to sever a plurality of smaller area photovoltaic cells 74 from roll 70. Smaller area cells 74 exiting the die cutting station may be collected by a conveyor belt, a container or a chute and forwarded to work stations.

By adhesively affixing the protective member to a roll of photovoltaic material, that material is protected during further cutting and handling. The smaller area cells cut from the roll retain the protective layer for subsequent handling, storage or other manipulation. When the cells are finally ready for use, the protective coating may be peeled off. In some instances, the protective layer may also function as an encapsulant for the photovoltaic cell. In such applications, the protective layer is transparent and may be opened to establish electrical contact to the cell.

The invention is not limited to devices having transparent oxide electrodes or to photovoltaic cells. The technique is generally applicable to severing electrical devices having a brittle outside layer in which short circuiting must be avoided. Large-area memory arrays, large-area integrated circuits and large-area liquid crystal displays are examples of such devices.

## Claims

1. A method for severing a smaller area semiconductor device (10") from a larger area semiconductor structure (10') without creating short circuits; the larger area structure (10')including amorphous semiconductor material (54) disposed on an electrically conductive substrate (11) and coated with a brittle electrically conductive coating (22) on the side thereof opposite to said substrate (11), the method being characterized by placing a rigid support member close to the severing line of the smaller area semiconductor device, the conductive coating (22) of said larger area semiconductor structure (10') being proximate said rigid support member; and utilizing a cutting die (60) to apply a shearing force to the substrate side of the larger area semiconductor structure (10') towards the rigid support member to punch through and sever the smaller area device (10") from the larger area structure.

2. A method according to claim 1, characterized by disposing a protective member (56) on the electrically conductive coating (22) before placing said rigid support member.

3. A method according to claim 2, characterized in that the protective member is selected from the group consisting of cardboard, paper, synthetic polymer and combinations thereof.

4. A method according to claim 2 or claim 3, characterized by removably adhering the protective layer (56) to said electrically conductive coating (22).

5. A method according to any one of the preceding claims, characterized by disposing said structure (10') on a resilient support member whereby said resilient support member (58) is adjacent to said protective member (56).

6. A method according to claim 5, wherein the resilient support member is selected from the group consisting of corrugated cardboard, rubber, plastics and paper.

7. A method according to any one of the preceding claims, wherein the brittle coating (22) is transparent.

## Revendications

1. Procédé pour découper des éléments semiconducteurs (10") de petite surface à partir d'une structure semi-conductrice (10') de grande surface sans créer de court-circuits ; la structure (10') de plus grande surface incluant un matériau semi-conducteur amorphe (54) disposé sur un substrat électriquement conducteur (11) et revêtu, du côté opposé audit substrat (11), d'un revêtement (22) électriquement conducteur, fragile, le procédé étant caractérisé par le fait que l'on place un composant support rigide près de la ligne de découpe des éléments semi-conducteurs de petite surface, le revêtement conducteur (22) de ladite structure semi-conductrice (10') de grande surface étant proche dudit élément support rigide; et que l'on utilise un poinçon de découpe (60) pour appliquer une force de cisaillement au côté substrat de la structure semi-conductrice (10') de grande surface, en direction du composant support rigide pour la poinçonner de part et d'autre et découper l'élément (10") de petite surface à partir de la structure de grande surface.

2. Procédé selon la revendication 1, caractérisé par le fait que l'on dispose un composant protecteur (56) sur le revêtement électriquement conducteur (22) avant de placer ledit composant support rigide.

3. Procédé selon la revendication 2, caractérisé par le fait que l'on choisit le composant protecteur dans le groupe constitué du carton, du papier, d'un polymère synthétique et de leurs combinaisons.

4. Procédé selon la revendication 2 ou la revendication 3, caractérisé par le fait que l'on fait adhérer, de façon amovible, la couche protectrice (56) audit revêtement électriquement conducteur (22).

5. Procédé selon l'une quelconque des revendications précédentes, caractérisé par le fait que l'on dispose ladite structure (10') sur un composant support élastique, ledit composant support élastique (58) étant adjacent audit composant protecteur (56).

6. Procédé selon la revendication 5, dans lequel on choisit le composant support souple dans le groupe constitué du carton ondulé, du caoutchouc, de la matière plastique et du papier.

7. Procédé selon l'une quelconque des revendications précédentes dans lequel le revêtement fragile (22) est transparent.

**Ansprüche**

1. Verfahren zum Ausschneiden eines kleinflächigen Halbleiterelements (10") aus einem großflächigen beschichteten Halbleitergefüge (10') ohne Kurzschlüsse, wobei das großflächige Gefüge (10') amorphes Halbleitermaterial (54) enthält, das auf einem elektrisch leitfähigen Substrat (11) angeordnet und auf der dem genannten Substrat (11) gegenüberliegenden Seite mit einer spröden, elektrisch leitfähigen Beschichtung (22) versehen ist, **dadurch gekennzeichnet,** daß ein starres Trägerelement in Nähe der Ausschneidlinie der kleinflächigen Halbleitervorrichtung angeordnet ist, wobei sich die leitfähige Beschichtung (22) des genannten großflächigen Halbleitergefüges (10') in Nähe des genannten starren Trägerelements befindet, und daß ein Schneidwerkzeug (60) verwendet wird, um eine Scherkraft auf die Substratseite des großflächigen Halbleitergefüges (10') in Richtung auf das starre Trägerelement auszuüben und so die kleinflächige Vorrichtung (10") von dem großflächigen Gefüge abzuschneiden und auszustanzen.

2. Verfahren nach Anspruch 1, **dadurch gekennzeichnet,** daß ein Schutzelement (56) vor Anbringung des genannten starren Trägerelements auf die elektrisch leitfähige Beschichtung (22) aufgebracht wird.

3. Verfahren nach Anspruch 2, **dadurch gekennzeichnet,** daß das Schutzelement aus einer Gruppe von Materialien ausgewählt wird, die Karton, Papier, synthetisches Polymer und Kombinationen dieser Materialien einschließt.

4. Verfahren nach Anspruch 2 oder Anspruch 3, **dadurch gekennzeichnet,** daß die Schutzschicht (56) ablösbar an der genannten elektrisch leitfähigen Beschichtung (22) haftet.

5. Verfahren nach einem der vorherigen Ansprüche, **dadurch gekennzeichnet,** daß das genannte Gefüge (10') auf einem elastischen Trägerelement angeordnet ist, wodurch das genannte elastische Trägerelement (58) an das genannte Schutzelement (56) angrenzt.

6. Verfahren nach Anspruch 5, wobei das elastische Trägerelement aus einer Gruppe von Materialien ausgewählt wird, die Wellpappe, Gummi, Kunststoff und Papier einschließt.

7. Verfahren nach einem der vorherigen Ansprüche, bei dem die spröde Beschichtung (22) transparent ist.

# FIG. 1

# FIG. 2

## FIG. 3A

## FIG. 3B

## FIG. 4

## FIG. 5